(19) Europäisches Patentamt
European Patent Office
Office européen des brevets

(11) **EP 2 658 128 B1**

(12) **EUROPÄISCHE PATENTSCHRIFT**

(45) Veröffentlichungstag und Bekanntmachung des Hinweises auf die Patenterteilung:
**05.11.2014 Patentblatt 2014/45**

(51) Int Cl.:
*H03K 17/97* *(2006.01)* *H03K 17/95* *(2006.01)*
*B62B 3/06* *(2006.01)*

(21) Anmeldenummer: **13177157.8**

(22) Anmeldetag: **30.09.2006**

(54) **Fahrschalter zur Steuerung eines Fahrantriebs eines kraftgetriebenen Flurförderzeugs**

Driving switch for controlling a drive mechanism of a powered industrial truck

Manipulateur pour la commande d'un entraînement de déplacement d'un chariot de manutention à moteur

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **24.10.2005 DE 202005016726 U**

(43) Veröffentlichungstag der Anmeldung:
**30.10.2013 Patentblatt 2013/44**

(62) Dokumentnummer(n) der früheren Anmeldung(en) nach Art. 76 EPÜ:
**06792337.5 / 1 941 614**

(73) Patentinhaber: **REMA Lipprandt GmbH & Co. KG**
**53175 Bonn (DE)**

(72) Erfinder:
• **Harmuth, Hans Rudi**
**53604 Bad Honnef (DE)**
• **Unger, Sebastian**
**51067 Köln (DE)**

(74) Vertreter: **Kluin, Jörg-Eden**
**Patentanwalt**
**Benrather Schlossallee 111**
**40597 Düsseldorf (DE)**

(56) Entgegenhaltungen:
**EP-A1- 0 900 719 DE-U1- 20 004 887**
**US-B1- 6 276 485**

## Beschreibung

Die Erfindung betrifft einen Fahrschalter zur Steuerung des Fahrantriebs eines kraftgetriebenen Flurförderzeugs. Aus der EP 1 180 473 A1 ist ein Fahrschalter bekannt, welcher einen Hall-Sensor sowie zwei Permanentmagnete auf einem kreissegmentförmig ausgebildeten Magnetträger umfasst. Der Magnetträger besitzt zwischen den Permanentmagneten eine Aussparung, in welche der Hall-Sensor aufrecht stehend hineinragt, so dass er von dem Magnetfeld, das von den mit ungleichnamigen Polen einander zugewandten Permanentmagneten erzeugt wird, durchflutet wird. Der Magnetträger ist derart mit einem von einem Bediener zu betätigenden Fahrschaltergriff verbunden, dass er bei einer Betätigung des Fahrschaltergriffs derart relativ zum Hall-Sensor verschwenkt wird, dass entweder der eine oder der andere Permanentmagnet näher an den Hall-Sensor herangelangt, so dass sich je nach Größe der Betätigung und damit der Verschwenkung des Magnetträgers das Magnetfeld, von dem der Hall-Sensor durchflutet wird, ändert, wodurch eine entsprechend dem Verschwenkungswinkel des Magnetträgers unterschiedliche Hall-Spannung induziert wird, welche als Signal zur Ansteuerung des Motors des Flurförderzeugs dient.

In der Praxis hat sich gezeigt, dass dieser Fahrschalter störanfällig ist. So kann sich die von dem Hall-Sensor erzeugte Hall-Spannung, die der Mittelstellung des Magnetträgers entspricht und somit als Steuersignal "neutral", d.h. Stillstand des Flurförderzeugs interpretiert werden soll, ändern, wenn beispielsweise die Position des Hall-Sensors zwischen dem Permanentmagneten dejustiert wird, was beispielsweise durch eine äußere Stoßeinwirkung hervorgerufen werden kann. Bei dem Fahrschalter ist daher ein Mikroschalter vorgesehen, der von dem Magnetträger in seiner Mittel-, d.h. Neutralstellung betätigt wird. Der Mikroschalter ist als Sicherheitsschalter angelegt, d.h. er verhindert ein Fahrsignal unabhängig von der aktuellen Hall-Spannung.

Zwar wird auf diese Weise verhindert, dass sich bei einer Dejustierung des Hall-Sensors das Flurförderzeug trotz Neutralstellung der Fahrschaltergriffe in Bewegung setzt, jedoch führt die Dejustierung zu einer Änderung der Abhängigkeit der Hall-Spannung von der Fahrschaltergriffstellung, so dass beispielsweise das Flurförderzeug bei einer Verlagerung des Magnetträgers aus seiner Mittelstellung nach Deaktivierung des Sicherheitsschalters sprunghaft oder zunächst nicht anfährt, je nachdem, in welche Richtung sich die Abhängigkeit der Hall-Spannung von der Fahrschaltergriffstellung durch die Dejustierung verändert hat.

Ferner kann bei starker Dejustierung des Hall-Sensors ein wiederholtes einseitiges Anschlagen eines Magneten auf eine Oberfläche des Hall-Sensors auftreten, welches eine wiederholte Verbiegung der Anschlusskontakte des Hall-Sensors verursacht. Dies kann nach einer Vielzahl von Betätigungen des Fahrschalters zu Ermüdungsbrüchen der Anschlusskontakte führen. Für den Bediener kann dies sehr gefährlich werden, da das dann von der Elektronik generierte Signal je nach Auslegung derselben dem Sollwert "volle Fahrgeschwindigkeit voraus" oder "volle Fahrgeschwindigkeit zurück" entspricht und - sofern keine weiteren Sicherheitssysteme vorhanden sind - sich das Fahrzeug abrupt in Bewegung setzt.

Darüber hinaus unterliegt der Mikroschalter aufgrund seiner mechanischen Arbeitsweise einem gewissen Verschleiß, so dass auch dessen sichere Funktion nicht über einen unbegrenzten Zeitraum gewährleistet ist. In der Praxis hat sich gezeigt, dass der Mikroschalter mit zunehmender Anzahl von Betriebszyklen erst immer später, d. h. bei größeren Schwenkwinkeln des Magnetträgers auslöst, was wiederum zu einem sprunghaften Anfahren des Flurförderzeugs führt.

Aus der Patentschrift US 6,276,485 B1 ist ein Fahrschalter mit mehreren Hall-Sensoren und einem Permanentmagneten bekannt.

Der Erfindung liegt daher die Aufgabe zugrunde, einen Fahrschalter zu schaffen, mit dem eine zuverlässigere Steuerung des Fahrantriebs eines Flurförderzeugs auch über eine große Anzahl von Betätigungszyklen des Fahrschalters sichergestellt ist.

Diese Aufgabe wird durch den in Anspruch 1 wiedergegebenen Fahrschalter gelöst.

Der erfindungsgemäße Fahrschalter umfasst zwei Hall-Sensoren, die einen seitlichen Abstand voneinander aufweisen, sowie eine Quelle magnetischer Feldlinien, die bei Betätigung des Fahrschalters relativ zu den Hall-Sensoren verlagerbar ist, so dass sich die magnetische Flussdichte in den Hall-Sensoren ändert. Durch die Verwendung von zwei Hall-Sensoren kann das Fahrsignal für eine Richtung, beispielsweise vorwärts, von dem einen Hall-Sensor erzeugt werden, wobei das Signal des anderen Hall-Sensors als Plausibilitätscheck und damit zur Sicherheitsüberprüfung verwendet wird. Dementsprechend wird das Fahrsignal für die andere Fahrtrichtung, beispielsweise rückwärts, von dem anderen Hall-Sensor erzeugt, wobei das Signal des einen Sensors dann als Plausibilitätscheck und damit der Sicherheitsüberprüfung dient.

Durch diese Ausgestaltung weist der erfindungsgemäße Fahrschalter gegenüber dem Stand der Technik unter anderem die folgenden Vorteile auf:

Die Hall-Sensoren können so in dem Magnetfeld angeordnet werden, dass sich bei der durch Betätigung des Fahrschalters ändernden magnetischen Flussdichte die Hall-Spannung des einen Hall-Sensors nahezu linear mit der Betätigung des Fahrschalters in einer Fahrtrichtung ändert, diejenige des anderen Hall-Sensors dementsprechend bei Betätigung des Fahrschalters in der anderen Fahrtrichtung ebenfalls nahezu linear ändert. Beide Hall-Sensoren können mit anderen Worten in einem Bereich betrieben werden, in dem ihr Ausgangssignal - die Hall-Spannung - analog zur Ansteuerung des Motors des Flurförderzeugs verwendet werden kann. Die Hall-Spannung des jeweils anderen Hall-Sensors, der nicht im nahezu linearen Bereich betrieben wird, kann dann einerseits zur Erkennung der Fahrtrichtung, andererseits der Sicherheitsüberprüfung dienen, indem eine Routine vorgesehen wird, die den Motor des Flurförderzeugs stillsetzt, wenn Hall-Spannungen von den beiden Hall-Sensoren erzeugt werden, die in einem nicht zu erwartenden Verhältnis zueinander stehen.

Besonders bevorzugt ist eine Ausführungsform des Fahrschalters, bei der die Hall-Sensoren auf einer Seite einer Platine flach angeordnet sind. Durch diese Maßnahme wird aufgrund der gegenüber einer stehenden, aus der EP 1 180 473 A1 bekannten Anordnung der Hall-Sensoren deren Empfindlichkeit gegen äußere mechanische Einflüsse wesentlich reduziert, da eine mechanisch erheblich stabilere Befestigung der Hall-Sensoren auf der Platine möglich ist. Die magnetische Flussdichte durch die Hall-Sensoren kann wesentlich erhöht werden, wenn - wie besonders bevorzugt - auf der den Hall-Sensoren gegenüberliegenden Seiten der Platine ein Joch zum Leiten der magnetischen Feldlinien vorgesehen ist. Durch Erhöhung der Flussdichte wird bewirkt, dass der Fahrschalter unempfindlicher gegen äußere, magnetische Einflüsse ist.

Grundsätzlich kann die Quelle magnetischer Feldlinien in beliebiger Weise, die eine Änderung der Flussdichte durch die Hall-Sensoren bei Betätigung des Fahrschalters bewirkt, ausgestaltet sein. Wegen der Einfachheit des Aufbaus und der Störunanfälligkeit ist es jedoch bevorzugt, als Quelle magnetischer Feldlinien zwei in einem seitlichen Abstand voneinander angeordnete Permanentmagnete vorzusehen, die - besonders bevorzugt - oberhalb der Hall-Sensoren angeordnet sind, eine umgekehrte Polarität aufweisen, wobei sich die Polachsen etwa senkrecht zur Platine erstrecken, und in einer zur Platine etwa parallelen Ebene bei Betätigung des Fahrschalters verlagerbar sind. Versuche haben gezeigt, dass bei dieser Anordnung bei einer Verlagerung der Permanentmagneten in einem Kreisbogen um ± 30° um eine Neutralstellung eine Änderung der Hall-Spannungen in den beiden Hall-Sensoren im annähernd linearen Bereich erzeugbar ist. Ferner besteht bei dieser Anordnung im Gegensatz zur Anordnung nach der EP 1 180 473 A1, bei der sich der Hall-Sensor zwischen den Magneten befindet, nicht mehr die Gefahr, dass es zu einer mechanischen Kollision der Magnete mit den Hall-Sensoren kommt, was die Betriebssicherheit des erfindungsgemäßen Fahrschalters abermals erhöht.

Die magnetische Flussdichte durch die Hall-Sensoren kann - was bevorzugt ist - nochmals erhöht werden, wenn die Permanentmagnete auf ihrer der Platine fort weisenden Seite über ein Joch zum Leiten der magnetischen Feldlinien verbunden sind.

Die Permanentmagnete sind - wie bereits oben erwähnt - vorzugsweise auf einer Kreisbahn verlagerbar, da Fahrschaltergriffe regelmäßig drehbetätigt werden und eine einfache Übertragung der Drehbetätigung auf einen die Permanentmagnete auf einer Kreisbahn verlagernden Magnetträger möglich ist.

Der erfindungsgemäße Fahrschalter weist eine Datenverarbeitungseinrichtung auf, welche die von den Hall-Sensoren erzeugten, elektrischen Signale aufnimmt und den Signalen eine Fahrgeschwindigkeit und Fahrtrichtung zuordnet, wobei zur Bestimmung der Fahrgeschwindigkeit das Signal eines Hall-Sensors Verwendung findet, bei welchem sich die magnetische Flussdichte in einem Bereich befindet, in dem das elektrische Signal eine Funktion der magnetischen Flussdichte ist, besonders bevorzugt im Falle von verlagerten Permanentmagneten sich zumindest nahezu linear mit der Verlagerung der Permanentmagnete ändert.

Der erfindungsgemäße Fahrschalter umfasst des weiteren eine Speicheranordnung, in welcher die zu erwartenden Sollwerte für die elektrischen Signale der Hall-Sensoren in Abhängigkeit der Fahrschalterstellung gespeichert sind und eine Einrichtung zum Vergleich der Sollwerte mit den von den Hall-Sensoren erzeugten Istwerten vorgesehen ist, die bei einem nicht zu erwartenden Verhältnis der Istwerte der Signale der beiden Hall-Sensoren den Fahrschalterzustand "neutral" bewirkt. Aufgrund dieser Speicheranordnung wird bei dem erfindungsgemäßen Fahrschalter in bevorzugter Weise eine Sicherheitsschaltung ausgebildet, die sicherstellt, dass das Flurförderzeug bei unerwarteten Signalverhältnissen, die auf einen Fehler in dem Fahrschalter hindeuten, stillgesetzt wird. Da diese Sicherheitsschaltung vollständig elektronisch arbeitet, unterliegt sie im Gegensatz zum Stand der Technik keinem mechanischen Verschleiß.

Der Fahrschalterzustand "neutral" wird ebenfalls bewirkt, wenn die Einrichtung zum Vergleich des Soll- und Istwertes solche Istwerte erfasst, die das für die Neutralstellung zu erwartende Signalverhältnis aufweisen.

Ein bevorzugtes Ausführungsbeispiel des erfindungsgemäßen Fahrschalters soll nachfolgend anhand der beigefügten Zeichnungen im einzelnen beschrieben werden. Es zeigen:

Fig. 1     - schematisch - die Anordnung der Hall-Sensoren und der Permanentmagnete in einer Aufsicht;

Fig. 2     - ebenfalls schematisch - die Anordnung gemäß Fig. 1 in einer Seitenansicht (Ansicht A in Fig. 1);

Fig. 3     die Hall-Spannungen der beiden Hall-Sensoren in Abhängigkeit der Winkelauslenkung des Magnetträgers aus der Neutralstellung sowie

Fig. 4    - schematisch - den Ablauf der Datenverarbeitung in der Datenverarbeitungseinrichtung.

Das dargestellte Ausführungsbeispiel des erfindungsgemäßen Fahrschalters umfasst einen ersten Hall-Sensor 1 und einen zweiten Hall-Sensor 2, die auf einem Kreisbogen angeordnet mit seitlichem Winkelabstand flach auf einer Seite einer Platine 4 befestigt sind. Oberhalb der Platine 4 sind zwei Permanentmagnete 3, 6 an einem Joch 5 angebracht. Die Permanentmagnete 3 und 6 sind so ausgerichtet, dass ihre Polachsen parallel, jedoch in umgekehrter Richtung verlaufen. Das Joch 5 dient einerseits als Magnetträger, andererseits zum gebündelten Leiten der magnetischen Flusslinien von einem Permanentmagnet in den anderen.

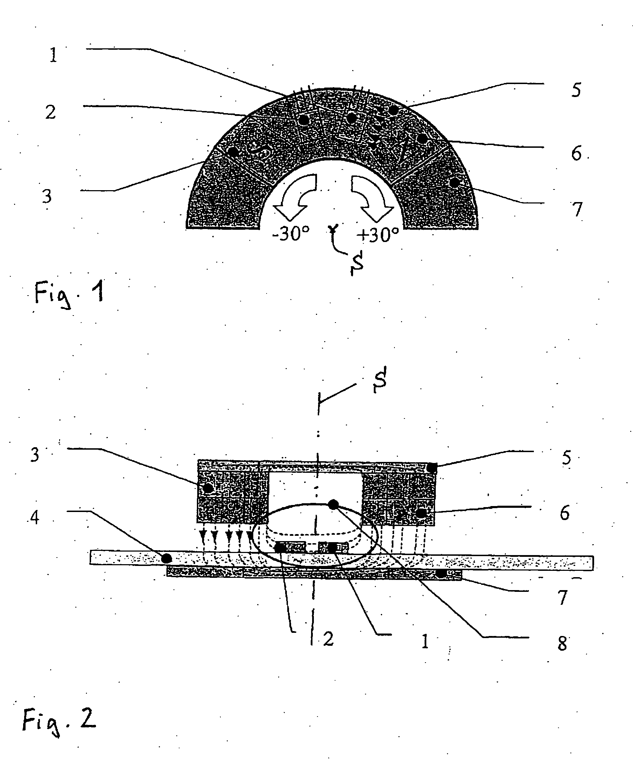

Das Joch 5 ist teilringförmig gestaltet und aus seiner in Fig. 1 und 2 dargestellten Mittellage um etwa ± 30° um eine Achse S verlagerbar.

Auf der den Hall-Sensoren 1, 2 gegenüberliegenden Seite der Platine 4 ist ebenfalls ein Joch 7 angeordnet, welches ebenfalls teilringförmig ausgebildet ist und sich über einen etwa 180° Winkelbereich derart erstreckt, dass das Joch 5 bei der Winkelauslenkung von ± 30° stets von dem Joch 7 unterdeckt wird, so dass die magnetischen Feldlinien stets durch das Joch 7 gebündelt werden und somit ein geschlossenes, stabilisiertes Magnetfeld, dessen Feldlinien die Hall-Sensoren durchdringen, gebildet wird. Das geschlossene Magnetfeld ist in Fig. 2 durch das mit 8 bezeichnete Oval symbolisiert.

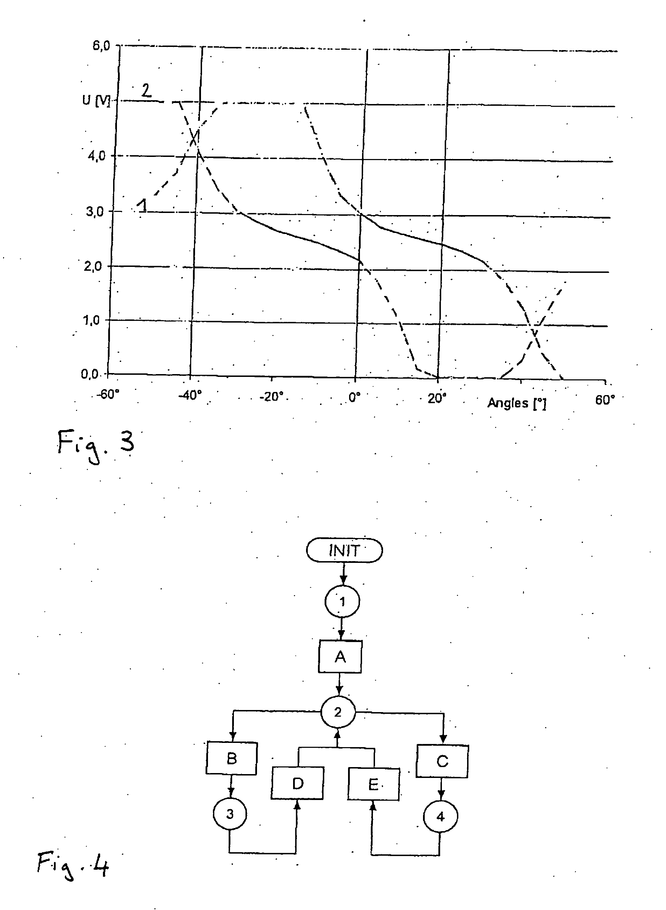

Die in den Hall-Sensoren 1, 2 aufgrund des Magnetfeldes 8 erzeugten Hall-Spannungen sind in Abhängigkeit von der Winkelauslenkung des Jochs 5 aus der in Fig. 1 und 2 dargestellten, mit 0° bezeichneten Neutralstellung in Fig. 3 dargestellt. Wie erkennbar ist, zeigt die Abhängigkeit der Hall-Spannung des Hall-Sensors 1 im Bereich von 0 bis +30° einen etwa linearen Verlauf zwischen 3 und 2 V. Dieser Bereich der Kurve ist durchgezogen dargestellt. Entsprechend zeigt die Hall-Spannung des Hall-Sensors 2 im Bereich von 0 bis - 30° eine nahezu lineare Abhängigkeit vom Winkel zwischen 2 und 3 V. Dieser Bereich ist ebenfalls durchgezogen dargestellt. Aufgrund dieser nahezu linearen Abhängigkeit werden die Hall-Spannungen von einer in der Zeichnung nicht dargestellten Datenverarbeitungseinrichtung analog zur Ansteuerung des Motors des Flurförderzeugs im Sinne der Vorgabe der Sollgeschwindigkeit verwendet. Die analogen SpannungsAusgangssignale werden vorzugsweise durch einen A/D-Wandler konvertiert, aufbereitet und dann in digitaler Form, beispielsweise seriell, über CAN Bus etc. an die Motorsteuerung weitergeleitet. Der Wert der Hall-Spannung des jeweils anderen Hall-Sensors, der sich in dem nahezu linearen Bereich nahezu in einem Plateau befindet, wie dies in Fig. 3 gestrichelt dargestellt ist, wird von der Datenverarbeitungseinrichtung zur Plausibilitätsüberprüfung in dem Sinne verwendet, dass der Motor des Flurförderzeugs stillgesetzt wird, wenn die Hall-Spannungswerte über gewisse Fehlertoleranzen hinaus nicht den erwarteten Sollwerten entsprechen. Hierzu wird von der Datenverarbeitungseinrichtung überprüft, ob der Wert der Hall-Spannung des jeweils anderen Hall-Sensors ober- oder unterhalb eines bestimmten Schwellenwerts liegt und in Abhängigkeit dessen ein Signal 0 oder 1 erzeugt. Der Motor des Flurförderzeugs wird nur dann mit einem Fahrsignal angesteuert, wenn der Wert der Hall-Spannung des jeweils anderen Hall-Sensors auf der erwarteten Seite der Schwelle liegt.

Eine bevorzugte Ausgestaltung der Datenverarbeitungseinrichtung, mit der die Hall-Sensoren 1, 2 verbunden sind, erzeugt die folgenden Ausgangssignale:

-    Motorsteuerung: Analoges Signal von dem jeweiligen Hall-Sensor ohne Richtungsinformation

-    Neutral: Digitales Signal, das erzeugt wird, wenn das für die Neutralstellung des Magnetträgers charakteristische Verhältnis der Hall-Spannungen der Hall-Sensoren 1 und 2 erfasst wird

-    Vorwärts: Digitales Signal über die Zielrichtung, erzeugt anhand des erfassten Verhältnis der Hall-Spannungen der Hall-Sensoren 1 und 2;

-    Rückwärts: Digitales, in entsprechender Weise erzeugtes Signal.

Die folgenden Werte werden von der Datenverarbeitungseinrichtung verwendet:

-    V1: Hall-Spannung des Hall-Sensors 1 bei voller Auslenkung des Magnetträgers im positiven Drehsinne, hier bei + 30°

-    V2: Hall-Spannung des Hall-Sensors 1 bei maximaler Auslenkung des Magnetträgers im negativen Drehsinne, hier bei - 30°

-    V3: Hall-Spannung des Hall-Sensors 1 am Rand der Neutralstellung im positiven Drehsinne

-    V4: Hall-Spannung des Hall-Sensors 1 am Rand der Neutralstellung im negativen Drehsinne

- V11: Hall-Spannung des Hall-Sensors 2 bei voller Auslenkung des Magnetträgers im positiven Drehsinne, hier bei + 30°

- V12: Hall-Spannung des Hall-Sensors 2 bei maximaler Auslenkung des Magnetträgers im negativen Drehsinne, hier bei - 30°

- V13: Hall-Spannung des Hall-Sensors 2 am Rand der Neutralstellung im positiven Drehsinne

- V14: Hall-Spannung des Hall-Sensors 2 am Rand der Neutralstellung im negativen Drehsinne.

Die Datenverarbeitungseinrichtung ist des weiteren so gestaltet, dass in der Neutralstellung die Ausgangssignale passiv sind, d.h. Motoransteuerung = 0, Neutralsignal = 1, Vorwärtssignal = 0, Rückwärtssignal = 0. Lediglich wenn der Magnetträger aus der Neutralposition verlagert und kein Störzustand detektiert werden schaltet die Datenverarbeitungseinrichtung in den aktiven Modus um.

Der Ablauf der Verarbeitung der Daten mittels der Datenverarbeitungseinrichtung ist in Fig. 4 dargestellt. In einem ersten Schritt A wird überprüft, ob sich die Hall-Spannung des Hall-Sensors 1 im Bereich zwischen V4 und V3 und der Wert der Hall-Spannung 2 im Bereich zwischen V14 und V13 befinden. Ist dies nicht der Fall, so wird überprüft, ob die Hall-Spannung des Hall-Sensors 1 größer V3 und die Hall-Spannung des Hall-Sensors 2 größer V13 ist. Ferner wird überprüft, ob die Hall-Spannung des Hall-Sensors 1 kleiner als V4 und die Hall-Spannung des Hall-Sensors 2 größer V14 ist. Sollte einer der vorstehenden Zustände festgestellt werden, so befinden sich die Ausgänge der Datenverarbeitungseinrichtung im Passivstatus, d.h. der Motor des Flurförderzeugs wird nicht angesteuert. Erst wenn keines der vorstehenden Hall-Spannungs-verhältnisse erfasst wird, die entweder auf eine Neutralstellung des Magnetträgers oder auf einen Fehlerzustand hin deuten, wird für den Fall, dass die Spannung des Hall-Sensors 1 kleiner V3 oder die Hall-Spannung des Hall-Sensors 2 größer V14 ist, anhand der jeweiligen, analogen Hall-Spannung das Ansteuersignal berechnet, und zwar für die Vorwärtsrichtung aus

(Hall-Spannung des Hall-Sensors 1 - V3) / (V01 - V03)*Vmax, wobei Vmax der der maximalen Geschwindigkeit entsprechende Hall-Spannungswert ist.

Dementsprechend wird das Ansteuersignal für die Rückwärtsrichtung errechnet gemäß

$$(V14 - \text{Hall-Spannung des Hall-Sensors 2}) / (V14 - V12) \times Vmax.$$

Nachdem der aktuelle Ansteuerwert ermittelt wurde, wird er mit dem Wert Vmax verglichen und, sollte der aktuelle Wert größer sein, auf Vmax begrenzt.

Versuche haben gezeigt, dass bei der beschriebenen Ausführungsform die folgenden Spannungswerte besonders geeignet sind:

V03 = 2,336V
V04 = 1,755V
V13 = 3,33V
V14 = 2,786V

Es versteht sich, dass bei anderen Ausführungsformen des erfindungsgemäßen Fahrschalters andere Spannungswerte notwendig sein können.

Als Standardwerte für die weiteren Parameter haben sich als geeignet erwiesen:

V01 = 4,140V
V02 = 0,327V
V11 = 4,526V
V12 = 1,300V

Diese Werte können jedoch geändert und in der Datenverarbeitungseinrichtung gespeichert werden, und zwar in den folgenden drei Schritten:

1. Maximale Auslenkung des Magnetträgers in positive Richtung und Abspeichern der gemessenen Hall-Spannungen des Hall-Sensors 1 als V01 und des Hall-Sensors 2 als V11

2. Maximale Auslenkung des Magnetträgers im negativen Drehsinne und Speichern der gemessenen Hall-Spannungen des Hall-Sensors 1 als V02 und des Hall-Sensors 2 als V12

3. Abspeichern der geänderten Werte in einem Permanentspeicher der Datenverarbeitungseinrichtung

**Patentansprüche**

**1.** Fahrschalter zur Steuerung des Fahrantriebs eines kraftgetriebenen Flurförderzeugs,
mit zwei Hall-Sensoren, die einen seitlichen Abstand voneinander aufweisen,
mit einer Quelle magnetischer Feldlinien, die bei Betätigung des Fahrschalters relativ zu den Hall-Sensoren verlagerbar ist, so dass sich die magnetische Flussdichte in den Hall-Sensoren ändert,
**dadurch gekennzeichnet, dass** der Fahrschalter eine Datenverarbeitungseinrichtung umfasst, welche die von den Hall-Sensoren erzeugten, elektrischen Signale aufnimmt und den Signalen eine Fahrgeschwindigkeit und Fahrtrichtung zuordnet, wobei zur Bestimmung der Fahrgeschwindigkeit das Signal eines Hall-Sensors Verwendung findet, bei welchem sich die magnetische Flussdichte in einem Bereich befindet, in dem das elektrische Signal eine Funktion der magnetischen Flussdichte ist, und
dass eine Speicheranordnung vorgesehen ist, in welcher die zu erwartenden Sollwerte für die elektrischen Signale der Hall-Sensoren in Abhängigkeit der Fahrschalterstellung gespeichert sind und dass eine Einrichtung zum Vergleich der Sollwerte mit den von den Hall-Sensoren erzeugten Istwerten vergleicht und bei einem nicht zu erwartenden Verhältnis der Istwerte der Signale der beiden Hall-Sensoren den Fahrschalterzustand "neutral" bewirkt.

**2.** Fahrschalter nach Anspruch 1, **dadurch gekennzeichnet, dass** die Einrichtung zum Vergleich der Soll- und Istwerte derart ausgebildet ist, dass sie den Fahrschalterzustand "neutral" bewirkt, wenn die Istwerte das für die Neutralstellung zu erwartende Signalverhältnis aufweisen.

**3.** Fahrschalter nach Anspruch 1 oder 2, **dadurch gekennzeichnet, dass** die HallSensoren auf einer Seite einer Platine flach angeordnet sind.

**4.** Fahrschalter nach Anspruch 3, **dadurch gekennzeichnet, dass** auf der den Hall-Sensoren gegenüberliegenden Seite der Platine ein Joch zum Leiten der magnetischen Feldlinien vorgesehen ist.

**5.** Fahrschalter nach einem der Ansprüche 1 bis 4, **dadurch gekennzeichnet, dass** die Quelle magnetischer Feldlinien zwei in einem seitlichen Abstand voneinander angeordnete Permanentmagnete umfasst.

**6.** Fahrschalter nach Anspruch 5, **dadurch gekennzeichnet, dass** die Permanentmagnete oberhalb der Hall-Sensoren angeordnet sind, eine umgekehrte Polarität aufweisen, wobei sich die Polachsen etwa senkrecht zu der Platine erstrecken, und in einer zur Platine etwa parallelen Ebene bei Betätigung des Fahrschalters verlagerbar sind.

**7.** Fahrschalter nach Anspruch 6, **dadurch gekennzeichnet, dass** die Permanentmagnete auf ihrer der Platine fortweisenden Seite über ein Joch zum Leiten der magnetischen Feldlinien verbunden sind.

**8.** Fahrschalter nach Anspruch 6 oder 7, **dadurch gekennzeichnet, dass** die Permanentmagnete auf einer Kreisbahn verlagerbar sind.

**Claims**

**1.** Drive switch for controlling the traction drive of a powered industrial truck,
having two Hall sensors which are spaced laterally apart,
having a source of magnetic field lines which, when the drive switch is actuated, can be moved relative to the Hall sensors with the result that the magnetic flux density in the Hall sensors changes,
**characterized**
**in that** the drive switch comprises a data processing device which accepts the electrical signals generated by the Hall sensors and assigns a velocity and direction of travel to the signals, wherein the signal of a Hall sensor is used to determine the velocity, in which signal the magnetic flux density is in a range in which the electrical signal is a function of the magnetic flux density, and in that a storage arrangement is provided in which the expected setpoint value for the electrical signals for the Hall sensors are stored as a function of the drive switch position, and in that a device for comparing the setpoint values with the actual values generated by the Hall sensors makes a comparison, and in the case of an unexpected ratio of the actual values of the signals of the two Hall sensors brings about the "neutral" drive switch state.

**2.** Drive switch according to Claim 1,
**characterized**
**in that** the device is designed to compare the setpoint values and actual values in such a way that it brings about the "neutral" drive switch state when the actual values have the signal ratio which is to be expected for the neutral position.

**3.** Drive switch according to Claim 1 or 2,
**characterized**
**in that** the Hall sensors are arranged flat on one side of a circuit board.

**4.** Drive switch according to Claim 3,
**characterized**
**in that** a yoke for conducting the magnetic field lines is provided on the side of the circuit board lying opposite the Hall sensors.

**5.** Drive switch according to one of Claims 1 to 4,
**characterized**
**in that** the source of the magnetic field lines comprises two permanent magnets arranged spaced laterally apart from one another.

**6.** Drive switch according to Claim 5,
**characterized**
**in that** the permanent magnets are arranged above the Hall sensors, have a reversed polarity, wherein the pole axes extend approximately perpendicularly with respect to the circuit board, and can be moved in a plane approximately parallel to the circuit board when the drive switch is actuated.

**7.** Drive switch according to Claim 6,
**characterized**
**in that** on their side extending away from the circuit board, the permanent magnets are connected by means of a yoke for conducting the magnetic field lines.

**8.** Drive switch according to Claim 6 or 7,
**characterized**
**in that** the permanent magnets can be moved on a circular path.

**Revendications**

**1.** Commutateur de déplacement destiné à la commande du mécanisme de déplacement d'un chariot de manutention à entraînement motorisé,
comprenant deux capteurs à effet Hall qui présentent un écart latéral l'un par rapport à l'autre,
comprenant une source de lignes de champ magnétique qui, lors de l'actionnement du commutateur de déplacement, peut être déplacée par rapport aux capteurs à effet Hall de telle sorte que la densité de flux magnétique dans les capteurs à effet Hall varie,
**caractérisé en ce que** le commutateur de déplacement comprend un dispositif de traitement de données qui collecte les signaux électriques générés par les capteurs à effet Hall et associe les signaux à une vitesse de déplacement et une direction de déplacement, la détermination de la vitesse de déplacement s'effectuant en utilisant le signal d'un capteur à effet Hall avec lequel la densité de flux magnétique se trouve dans une plage dans laquelle le signal électrique est une fonction de la densité de flux magnétique, et
**en ce qu'**il est prévu un arrangement de mémoire dans lequel sont enregistrées les valeurs de consigne attendues pour les signaux électriques des capteurs à effet Hall en fonction de la position du commutateur de déplacement, et **en ce qu'**un dispositif de comparaison compare les valeurs de consigne avec les valeurs réelles générées par les capteurs à effet Hall et, en présence d'un rapport non attendu des valeurs réelles des signaux des deux capteurs à effet Hall, rend « neutre » l'état du commutateur de déplacement.

**2.** Commutateur de déplacement selon la revendication 1, **caractérisé en ce que** le dispositif de comparaison des valeurs de consigne et réelles est configuré de telle sorte qu'il rend « neutre » l'état du commutateur de déplacement lorsque les valeurs réelles présentent le rapport de signal attendu pour la position neutre.

**3.** Commutateur de déplacement selon la revendication 1 ou 2, **caractérisé en ce que** les capteurs à effet Hall sont disposés à plat sur un côté d'une platine.

**4.** Commutateur de déplacement selon la revendication 3, **caractérisé en ce qu'**une culasse destinée à guider les lignes de champ magnétique est prévue sur le côté de la platine opposé aux capteurs à effet Hall.

**5.** Commutateur de déplacement selon l'une des revendications 1 à 4, **caractérisé en ce que** la source de lignes de champ magnétique comprend deux aimants permanents disposés avec un écart latéral l'un par rapport à l'autre.

**6.** Commutateur de déplacement selon la revendication 5, **caractérisé en ce que** les aimants permanents sont disposés au-dessus des capteurs à effet Hall et présentent une polarité inversée, les axes polaires s'étendant approximativement perpendiculairement à la platine, et pouvant être déplacés dans un plan approximativement parallèle à la platine lors de l'actionnement du commutateur de déplacement.

**7.** Commutateur de déplacement selon la revendication 6, **caractérisé en ce que** les aimants permanents, sur leur côté à l'opposé de la platine, sont reliés par le biais d'une culasse destinée à conduire les lignes de champ magnétique.

**8.** Commutateur de déplacement selon la revendication 6 ou 7, **caractérisé en ce que** les aimants permanents peuvent être déplacés sur une trajectoire circulaire.

Fig. 1

Fig. 2

6,0

U [V]

4,0

3,0

2,0

1,0

0,0

-60°    -40°    -20°    0°    20°    Angles [°]    60°

**Fig. 3**

INIT

1

A

2

B    D    E    C

3    4

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1180473 A1
- US 6276485 B1